# DEMANDE DE BREVET EUROPEEN

(11) **EP 4 280 230 A1**
(43) Date de publication de la demande: **22.11.2023**
(21) Numéro de dépôt: 23172614.2
(22) Date de dépôt: 10.05.2023
(51) Int. Cl.: H01B 7/36, H01B 7/32, G01R 19/155

(54) **CÂBLE ÉLECTRIQUE ÉQUIPÉ D'UN DISPOSITIF D'INDICATION DE LA PRÉSENCE D'UNE TENSION ÉLECTRIQUE**

(30) Priorité: 18.05.2022 FR 2204707
(71) Demandeur: Nexans, 92400 Courbevoie (FR)
(72) Inventeur: DEMULE, Christophe, 71190 LAIZY (FR); SANTANA JUNIOR, Miguel, 69110 STE FOY LES LYON (FR); GRIOT, Samuel, 69007 LYON (FR)
(74) Mandataire: Ipsilon

(57) **Abrégé**

Ce câble électrique (10), comportant au moins un conducteur (12), comporte en outre un dispositif d'indication de la présence d'une tension électrique à l'intérieur du câble (10). Le dispositif comporte : au moins une couche (14) couvrant au moins partiellement la surface extérieure du câble (10) en au moins une région du câble (10) ; un moyen d'émission d'un signal indicateur de la présence d'une tension électrique à l'intérieur du câble (10).

## Description

La présente invention se rapporte à un câble électrique équipé d'un dispositif d'indication de la présence d'une tension électrique à l'intérieur de ce câble.

L'invention appartient au domaine des câbles électriques. Elle trouve à s'appliquer à tout type de réseaux de câbles électriques et en particulier, mais pas uniquement, aux réseaux électriques basse tension.

Il est actuellement impossible de savoir si une tension électrique est présente à l'intérieur d'un câble électrique sans utiliser d'outil ou un dispositif dédié de test tel qu'un voltmètre.

La présente invention a pour but de remédier aux inconvénients précités de l'art antérieur.

Dans ce but, la présente invention propose un câble électrique comportant au moins un conducteur, remarquable en ce qu'il comporte en outre un dispositif d'indication de la présence d'une tension électrique à l'intérieur du câble, le dispositif comportant :
au moins une couche couvrant au moins partiellement la surface extérieure du câble en au moins une région du câble ;
un moyen d'émission d'un signal indicateur de la présence d'une tension électrique à l'intérieur du câble.

Ainsi, la présente invention permet d'écarter tout risque d'intervention par erreur sur un câble sous tension qui présenterait un danger pour la sécurité, telle qu'une opération de découpe. En outre, la présente invention ne nécessite aucun outil ni équipement supplémentaire en dehors du câble lui-même. Par ailleurs, l'invention permet de savoir de façon très simple si une tension électrique est présente à l'intérieur du câble, grâce au moyen d'émission du signal indicateur de la présence d'une tension.

Dans un mode particulier de réalisation, le dispositif d'indication de la présence d'une tension électrique à l'intérieur du câble comporte en outre au moins un composant électronique contenu dans l'au moins une couche et réagissant à la présence d'un champ électrique et le moyen d'émission est connecté à l'au moins un composant électronique.

Dans un mode particulier de réalisation, l'au moins une couche comporte une pluralité de couches de formes différentes disposées en une pluralité de régions de la surface extérieure du câble.

La multiplication des emplacements du câble où a lieu la surveillance de l'apparition d'une tension électrique permet d'améliorer la détection de la présence de cette tension.

Dans un mode particulier de réalisation, moins de dix composants électroniques pourraient être intégrés dans le câble.

Ainsi, la détection de la présence d'une tension électrique dans le câble est obtenue grâce à un nombre très limité de composants électroniques.

Dans un mode particulier de réalisation, le signal indicateur de la présence d'une tension électrique à l'intérieur du câble est un signal lumineux.

L'intervenant installateur ou utilisateur du câble est ainsi immédiatement informé, d'un simple coup d'oeil, de la présence d'une tension électrique.

Dans un mode particulier de réalisation, le signal indicateur de la présence d'une tension électrique à l'intérieur du câble est un signal sonore.

L'intervenant installateur ou utilisateur du câble est ainsi immédiatement informé de la présence d'une tension électrique sans même avoir à regarder le câble.

Dans un mode particulier de réalisation, le moyen d'émission du signal indicateur de la présence d'une tension électrique à l'intérieur du câble comporte un moyen de déclenchement de cette émission en présence d'une partie du corps humain d'un intervenant à une distance prédéterminée du câble.

Cela permet d'éviter de déclencher l'émission du signal indicateur de la présence d'une tension électrique si personne ne se trouve à proximité du câble.

### Brève description des dessins

D'autres aspects et avantages de l'invention apparaîtront à la lecture de la description détaillée ci-après de modes particuliers de réalisation, donnés à titre d'exemples nullement limitatifs, en référence aux dessins annexés, dans lesquels :
[Fig. 1] est une représentation schématique d'un câble électrique conforme à la présente invention, dans un mode particulier de réalisation.
[Fig. 2] est une représentation d'un schéma électrique équivalent montrant le dispositif d'indication de la présence d'une tension électrique compris dans un câble conforme à la présente invention, dans un mode particulier de réalisation.

### Description de mode(s) de réalisation

Le câble électrique conforme à la présente invention peut être tout type de câble, notamment mais non nécessairement un câble faisant partie d'un réseau électrique basse tension.

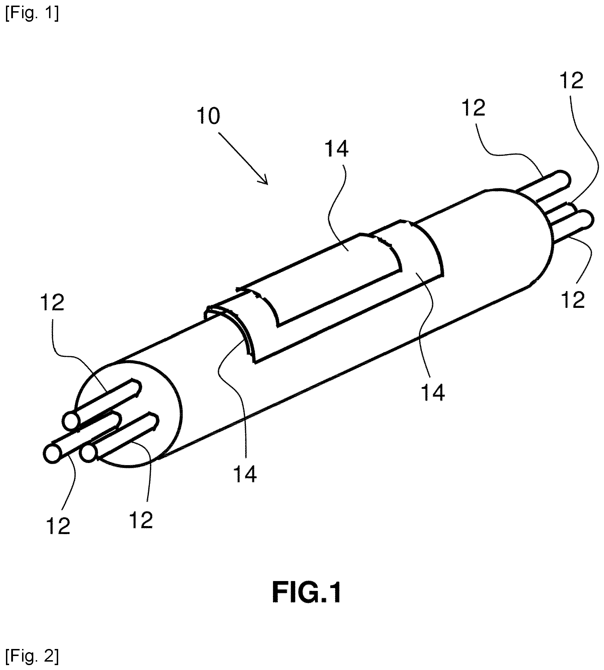

Comme le montre la figure 1, le câble électrique 10 conforme à la présente invention comporte au moins un conducteur 12. Dans le mode particulier de réalisation illustré, le câble 10 comporte à titre d'exemple nullement limitatif trois conducteurs 12.

Conformément à la présente invention, le câble électrique 10 comporte en outre un dispositif d'indication de la présence d'une tension électrique à l'intérieur du câble 10.

Le dispositif d'indication de la présence d'une tension électrique à l'intérieur du câble 10 comporte au moins une couche 14 couvrant au moins partiellement la surface extérieure du câble 10 en au moins une région du câble 10. Dans le mode particulier de réalisation illustré, le dispositif comporte à titre d'exemple nullement limitatif trois couches 14 qui ne couvrent pas les mêmes régions de la surface extérieure du câble. Toutefois, dans cet exemple non limitatif, certaines régions de la surface extérieure du câble sont couvertes simultanément par les trois couches 14. Plus généralement, il peut y avoir une pluralité de couches 14 disposées en une pluralité de régions de la surface extérieure du câble 10, ces régions pouvant être disjointes ou pouvant se chevaucher.

Parmi les couches 14, on peut prévoir une ou plusieurs couches du type suivant : couche conductrice, couche réflectrice, couche protectrice, polarisée, couche extérieure transparente ou non conductrice pour une activation du dispositif d'indication de la présence d'une tension par le toucher, couche réagissant à une faible tension électrique en changeant d'état (passant par exemple d'une couche opaque à une couche transparente en présence d'une faible tension électrique), couche adhésive, couche de montage de circuit électronique, couche semi-conductrice, couche diélectrique. Les couches autres que la couche de montage de circuit électronique servent à la signalisation de la présence d'une tension électrique à l'intérieur du câble.

Les couches 14 peuvent être de formes et de dimensions différentes.

L'au moins une couche 14 peut comporter deux couches conductrices, une couche intermédiaire située entre ces deux couches et une couche de montage de circuit électronique. En effet, de façon optionnelle mais non obligatoire, le dispositif d'indication de la présence d'une tension électrique à l'intérieur du câble 10 peut comporter en outre au moins un composant électronique (non visible sur la figure 1) contenu dans ladite au moins une couche 14, par exemple imprimé sur cette couche 14, et réagissant à la présence d'un champ électrique.

En effet, la présence d'une tension électrique à l'intérieur d'un ou plusieurs des conducteurs 12 va engendrer un champ électrique et c'est la détection de ce champ électrique par l'au moins un composant électronique qui va permettre de signaler la présence d'une tension électrique à l'intérieur du câble 10. L'au moins un composant électronique a pour fonction de mettre en forme les signaux captés en cas de présence d'une tension électrique dans le câble, de façon à restituer cette détection sous forme d'une signalisation.

A cet effet, le dispositif d'indication de la présence d'une tension électrique à l'intérieur du câble 10 comporte également un moyen d'émission d'un signal indicateur de la présence d'une tension électrique à l'intérieur du câble 10. Ce moyen d'émission (non visible sur la figure 1) peut par exemple être connecté à l'au moins un composant électronique.

Avantageusement, on peut prévoir d'intégrer dans le câble 10 moins de dix composants électroniques.

Le signal indicateur de la présence d'une tension électrique à l'intérieur du câble 10, émis par le moyen d'émission précité, peut être un signal lumineux ou un signal sonore. Le signal lumineux peut par exemple être émis par une diode électroluminescente agencée dans ou sur une ou plusieurs couches 14. Le signal lumineux peut se présenter sous la forme d'une couleur unique prédéterminée prenant éventuellement la forme d'un symbole, qui apparaît uniquement lorsqu'une tension est détectée, ou sous forme d'un voyant allumé en permanence qui change de couleur en cas de détection d'une tension.

Dans un mode particulier de réalisation, on peut prévoir que le moyen d'émission ne fonctionne pas en permanence. Pour cela, il peut comporter un moyen de déclenchement de l'émission du signal précité uniquement en présence d'une partie du corps humain d'un intervenant se tenant à une distance prédéterminée dudit câble 10, typiquement lorsque l'intervenant approche la main à quelques millimètres du câble 10. Cela crée une augmentation locale du champ électrique permettant d'engendrer suffisamment de différence de potentiel pour que le dispositif d'indication de la présence d'une tension électrique à l'intérieur du câble s'active.

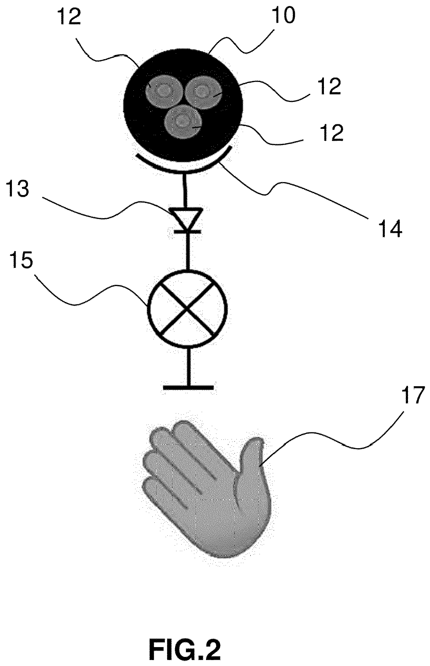

Comme le montre la figure 2, à titre d'exemple nullement limitatif, l'au moins une couche 14 peut comporter, comme composants électroniques, une diode 13 et une lampe 15, imprimées sur la couche 14 ou intégrées sur ou dans cette couche 14 par toute autre technique. La main 17 d'un utilisateur placée à proximité de la couche 14 déclenche l'activation du dispositif d'indication de la présence d'une tension électrique.

En variante, sans présence physique à proximité du câble, une présence métallique proche du câble, telle qu'un chemin de câbles, peut également activer le dispositif d'indication de la présence d'une tension électrique à l'intérieur du câble.

## Revendications

1. Câble électrique (10) comportant au moins un conducteur (12), **caractérisé en ce qu'**il comporte en outre un dispositif d'indication de la présence d'une tension électrique à l'intérieur dudit câble (10), ledit dispositif comportant :
au moins une couche (14) couvrant au moins partiellement la surface extérieure dudit câble (10) en au moins une région dudit câble (10) ;
un moyen d'émission d'un signal indicateur de la présence d'une tension électrique à l'intérieur dudit câble (10).

2. Câble électrique (10) selon la revendication 1, **caractérisé en ce que** ledit dispositif d'indication de la présence d'une tension électrique à l'intérieur dudit câble (10) comporte en outre au moins un composant électronique contenu dans ladite au moins une couche (14) et réagissant à la présence d'un champ électrique et **en ce que** ledit moyen d'émission est connecté audit au moins un composant électronique.

3. Câble électrique (10) selon la revendication 1 ou 2, **caractérisé en ce que** ladite au moins une couche (14) comporte une pluralité de couches de formes différentes disposées en une pluralité de régions de la surface extérieure dudit câble (10).

4. Câble électrique (10) selon la revendication 2, **caractérisé en ce qu'**il comporte moins de dix composants électroniques.

5. Câble électrique (10) selon l'une quelconque des revendications précédentes, **caractérisé en ce que** ledit signal indicateur de la présence d'une tension électrique à l'intérieur dudit câble (10) est un signal lumineux.

6. Câble électrique (10)selon l'une quelconque des revendications 1 à 4, **caractérisé en ce que** ledit signal indicateur de la présence d'une tension électrique à l'intérieur dudit câble (10) est un signal sonore.

7. Câble électrique (10) selon l'une quelconque des revendications précédentes, **caractérisé en ce que** ledit moyen d'émission dudit signal indicateur de la présence d'une tension électrique à l'intérieur dudit câble (10) comporte un moyen de déclenchement de ladite émission en présence d'une partie du corps humain d'un intervenant à une distance prédéterminée dudit câble (10).
